# EUROPÄISCHE PATENTSCHRIFT

(11) **EP 3 281 505 B1**
(45) Veröffentlichungstag und Bekanntmachung des Hinweises auf die Patenterteilung: **19.02.2020**
(21) Anmeldenummer: 16719198.0
(22) Anmeldetag: 23.03.2016
(51) Int. Cl.: H05K 7/20

(54) **SCHALTSCHRANKANORDNUNG MIT EINEM KÜHLGERÄT FÜR DIE KÜHLUNG DER IM INNENRAUM EINES SCHALTSCHRANKS AUFGENOMMENEN LUFT**
SWITCHGEAR CABINET ARRANGEMENT WITH A COOLING UNIT FOR COOLING THE AIR ADMITTED TO THE INTERIOR OF A SWITCHGEAR CABINET
SYSTÈME D'ARMOIRE DE DISTRIBUTION AVEC UN APPAREIL DE REFROIDISSEMENT DE L'AIR ADMIS À L'INTÉRIEUR D'UNE ARMOIRE DE DISTRIBUTION

(30) Priorität: 10.04.2015 DE 102015105490
(43) Veröffentlichungstag der Anmeldung: 14.02.2018
(73) Patentinhaber: Rittal GmbH & Co. KG, 35745 Herborn (DE)
(72) Erfinder: CACHO ALONSO, Juan Carlos, 38102 Braunschweig (DE); HENRICHS, Bernd, 91567 Herrieden (DE)
(74) Vertreter: Angerhausen, Christoph
(86) Internationale Anmeldenummer: PCT/DE2016/100143
(87) Internationale Veröffentlichungsnummer: WO 2016/162015

(56) Entgegenhaltungen:
- EP-A1- 2 762 810

## Beschreibung

Die Erfindung geht aus von einer Schaltschrankanordnung, mit einem Schaltschrank, in dem an die Luft im Schaltschrankinnenraum Wärme abgebende Komponenten aufgenommen sind, und mit einem Kühlgerät für die Kühlung der im Innenraum des Schaltschranks aufgenommenen Luft, das einen Innenkreis, durch den die zu kühlende Luft aus einem Schaltschrankinnenraum geführt ist, und einen von dem Innenkreis fluidisch abgetrennten Außenkreis aufweist, durch den Umgebungsluft geführt ist, wobei die Luft aus dem Schaltschrankinnenraum mit einem ersten Lüfter durch den Innenkreis und Umgebungsluft der Schaltschrankanordnung mit einem zweiten Lüfter durch den Außenkreis geführt ist. In dem Innenkreis ist ein erster Wärmetauscher und in dem Außenkreis ein zweiter Wärmetauscher angeordnet, zwischen denen ein Kältemittel zirkuliert wird. Die Wärmetauscher weisen eine Luftdurchlassrichtung auf, entlang welcher die Wärmetauscher zwischen einer Lufteinlassseite und einer Luftauslassseite luftdurchlässig sind, und wobei beiden Wärmetauschern jeweils ein erstes Luftleitelement an der Lufteinlassseite vorgelagert ist, das sich unter einem Winkel mit 5 < β < 45° zu der Lufteinlassseite erstreckt und einen Luftkanal zwischen sich und der Lufteinlassseite bildet, der sich entlang einer Abmessung der Lufteinlassseite verjüngt, wobei die beiden ersten Luftleitelemente jeweils ein Wandabschnitt einer Schottwand sind, die den Innenkreis von dem Außenkreis fluidisch abtrennt, wobei die beiden ersten Luftleitelemente an diametral gegenüber liegenden Enden der Schottwand ausgebildet sind. Eine derartige Schaltschrankordnung ist bekannt aus der GB 2 213 920 A. Eine ähnliche Schaltschrankanordnung ist außerdem bekannt aus der EP 2 762 810 A1.

Der erste und der zweite Wärmetauscher können Bestandteil eines Kältemittelkreislaufs sein, der beispielsweise Bestandteil einer Kältemaschine ist. Die Zirkulation des Kältemittels kann mit Hilfe eines Verdichters oder einer Pumpe erfolgen. Der erste und der zweite Wärmetauscher können auch Bestandteil eines passiven Kältemittelkreislaufs sein, beispielsweise einer Heatpipe-Anordnung. Die Wärmetauscher weisen eine Luftdurchlassrichtung auf, entlang welcher sie zwischen einer Lufteinlassseite und einer Luftauslassseite luftdurchlässig sind.

Ein weiteres Kühlgerät ist beispielsweise aus der DE 10 2012 108 110 A1 bekannt. Das Kühlgerät kann dabei als Wandanbau- oder als Dachaufbaugerät ausgebildet sein. Über eine Lufteinlassöffnung wird Luft aus dem Schaltschrankinnenraum in den Innenkreis eingeleitet. Die erwärmte Luft aus dem Schaltschrankinnenraum passiert den als Luft-KältemittelKreislauf ausgebildeten Wärmetauscher im Innenkreis und wird als gekühlte Luft über eine Luftauslassöffnung in den Schaltschrankinnenraum zurückgeführt. Der Außenkreis weist eine weitere Lufteinlassöffnung und eine weitere Luftauslassöffnung auf, über welche Umgebungsluft der Schaltschrankanordnung in den Außenkreis eingeleitet, durch den im Außenkreis angeordneten Luft-Kältemittel-Wärmetauscher hindurch und über die Luftauslassöffnung zurück in die Umgebung geleitet wird.

Für einen effektiven Wärmeaustausch ist es erforderlich, dass die Wärmetauscher möglichst optimal von der jeweiligen Luft angeströmt werden. Dazu ist es wiederum erforderlich, dass die jeweilige Luft, bevor sie auf den jeweiligen Wärmetauscher trifft, präzise in die jeweilige Luftdurchlassrichtung des betreffenden Wärmetauschers gelenkt wird. Übliche Wärmetauscher sind häufig als flächige Bauteile ausgebildet, wobei sie in Luftdurchlassrichtung wesentlich flacher als in den beiden dazu senkrechten Raumrichtungen bemessen sind. Bei als Wandanbaugerät ausgebildeten Kühlgeräten ist der Wärmetauscher daher aus Platzgründen häufig so ausgerichtet, dass sich seine Luftdurchlassrichtung in Tiefenrichtung des Kühlgerätes erstreckt, um das Baumaß des Kühlgerätes in Tiefenrichtung zu beschränken. Da die Lufteinlassöffnung und die Luftauslassöffnung, über die der Innenkreis mit dem Schaltschrankinnenraum und der Außenkreis mit der Umgebung in Verbindung steht, jedoch vertikal versetzt zu dem jeweiligen Wärmetauscher angeordnet sind, erfordert diese Ausrichtung des Wärmetauschers in Bezug auf die Lufteinlass- und Luftauslassöffnungen, dass die in den Innenkreis bzw. den Außenkreis eingeleitete Luft effektiv vor die Lufteinlassseite des Wärmetauschers geleitet wird, damit sie den Wärmetauscher optimal durchsetzen kann.

Dies ist bei den aus dem Stand der Technik bekannten Kühlgeräten bisher nur unzureichend gelöst. Häufig werden die Wärmetauscher zur Optimierung der Anströmung schräg gestellt, wobei sie jedoch immer noch seitlich angeströmt werden, was zu einem starken Luftgeschwindigkeitsgradienten über die Lufteinlassseite des Wärmetauschers führt. Somit bilden sich lokale Luftgeschwindigkeitsspitzen aus, während andere Bereiche des Wärmetauschers kaum oder gar nicht von Luft durchsetzt werden. In den Bereichen, in denen der Wärmetauscher mit besonders hohen Luftgeschwindigkeiten durchsetzt wird, kann dies beispielsweise dazu führen, dass im Wärmetauscher, etwa an den Lamellen dieses, gebildetes Kondensat ablöst und in den Schaltschrankinnenraum geschleudert wird, was unerwünscht ist.

Um diesen Übertritt von Kondenswasser in den Schaltschrankinnenraum zu vermeiden, ist bei der DE 10 201 2 108 110 A1 beispielsweise vorgesehen, dass der sich im Innenkreis befindende Wärmetauscher oberhalb von der Luftauslassöffnung des Innenkreises angeordnet ist, so dass sich ablösendes Kondensat in einer Kondensatauffangwanne im unteren Bereich des Innenkreises abgeführt werden kann. Dies bedingt jedoch wiederum einen erhöhten Platzbedarf für die Unterbringung sämtlicher Gerätebauteile.

Es ist daher die Aufgabe der Erfindung, ein Kühlgerät der bekannten Art derart weiterzuentwickeln, dass es einen verbesserten Wirkungsgrad aufweist, bei gleichzeitig geringen Bauabmessungen und wirkungsvollem Schutz gegenüber ungewolltem Übertritt von Kondenswasser in den Schaltschrankinnenraum.

Diese Aufgabe wird durch ein Kühlgerät mit den Merkmalen des Anspruchs 1 gelöst. Die abhängigen Ansprüche betreffen jeweils vorteilhafte Ausführungsformen der Erfindung.

Es ist vorgesehen, dass das einem ersten Wärmetauscher vorgelagerte erste Luftleitelement einen unteren Bereich der Lufteinlassseite verdeckt, so dass der erste Wärmetauscher in diesem Bereich nicht von Luft durchströmt ist. Damit wird das Herausschleudern von Kondensat aus dem Wärmetauscher weiter erschwert.

Es kann vorgesehen sein, dass die Lufteinlassseite eine Vorderseite und die Luftauslassseite eine Rückseite des Wärmetauschers mit dem vorgelagerten ersten Luftleitelement ist, die über Seitenflächen des Wärmetauschers voneinander beabstandet sind, wobei der Wärmetauscher über eine der Seitenflächen angeströmt ist, und wobei der Luftkanal zu dieser Seitenfläche hin geöffnet ist und sich zu einer gegenüber liegenden Seitenfläche hin verjüngt.

Die angeströmte Seitenfläche kann dabei ein zweites Luftleitelement aufweisen, über das die den Wärmetauscher seitlich anströmende Luft vor die Lufteinlassseite geführt ist.

Das Kühlgerät kann eine erste Kühlgerätewand mit einem Lufteinlass und einem Luftauslass aufweisen, zwischen denen der Innenkreis gebildet ist, wobei das zweite Luftleitelement beabstandet von dem Wärmetauscher in dem Innenkreis an die erste Kühlgerätewand angrenzt und sich von dort zu der Lufteinlassseite des Wärmetauschers erstreckt. Die Kühlgerätewand kann eine Montageseite des Kühlgeräts sein, über die das Kühlgerät mit einem Schaltschrank verbunden ist, so dass der Lufteinlass und der Luftauslass in die Schaltschrankinnenraum münden.

Weiterhin kann das Kühlgerät eine zweite Kühlgerätewand mit einem Lufteinlass und einem Luftauslass aufweisen, zwischen denen der Außenkreis gebildet ist, wobei das zweite Luftleitelement beabstandet von dem Wärmetauscher in dem Außenkreis an die zweite Kühlgerätewand angrenzt und sich von dort zu der Lufteinlassseite des Wärmetauschers erstreckt.

Der Wärmetauscher kann insbesondere ein Luft-Kältemittel-Wärmetauscher, vorzugsweise ein Lamellen-Wärmetauscher oder ein Microchannel-Wärmetauscher sein, der in dem unteren Bereich und/oder angrenzend daran einen Kondensatabscheider aufweist. Die Lamellen können von einem Rohrleitungssystem, durch das das Kühlmittel zwischen den Wärmetauschern zirkuliert ist, durchsetzt sein.

Der Winkel, mit dem sich jeweils ein erstes Luftleitelement der Wärmetauscher zur jeweiligen Lufteinlassseite erstreckt, beträgt vorzugsweise zwischen 10° und 25° und besonders bevorzugt zwischen 15 und 20°.

Die Schottwand mit den beiden Luftleitelementen kann einstückig ausgebildet sein, beispielsweise als ein Kunststoff- oder ein Blechformteil.

Es kann weiterhin vorgesehen sein, dass das Kühlgerät einen Luftauslass zur Ausblasung von mittels des in dem Innenkreis angeordneten Wärmetauscher gekühlter Luft aufweist, wobei die Luftauslassseite des in dem Innenkreis angeordneten Wärmetauschers mit dem Luftauslass überlappt. Das Kühlgerät erlaubt es, dass die Strömungsgeschwindigkeit der Luft, mit welcher diese durch den Wärmetauscher hindurch tritt, so niedrig gehalten wird, dass ein ungewolltes Herausschleudern von Kondensat aus dem Wärmetauscher wirkungsvoll vermieden wird. Dies erlaubt es wiederum, die Luftauslassseite des Wärmetauschers in dem Luftauslass, welcher unmittelbar in den Schaltschrankinnenraum münden kann, anzuordnen. Dabei kann der Öffnungsquerschnitt des Luftauslasses parallel zu der Luftauslassseite angeordnet sein und sich über die gesamte Luftauslassseite erstrecken.

Das erste Luftleitelement kann unmittelbar angrenzend an die Lufteinlassseite des Wärmetauschers ausgebildet sein. So kann sich das erste Luftleitelement, das zwischen sich und der Lufteinlassseite des Wärmetauschers den Luftkanal bildet, in einem Randbereich an die Lufteinlassseite angrenzend ausgebildet sein und sich von dieser unter dem Winkel, der größer als 0° und kleiner als 90° ist, erstrecken. Der Winkel beträgt vorzugsweise zwischen 20° und 60° und besonders bevorzugt zwischen 25 und 45°.

Die Abmessung der Lufteinlassseite, entlang welcher sich der Luftkanal verjüngt, kann sich senkrecht zu der Luftdurchlassrichtung des betreffenden Wärmetauschers erstrecken. Bei einem Wandanbaugerät kann sie sich vertikal erstrecken.

Durch die Verwendung eines Luftkanals der zuvor beschriebenen Art wird erreicht, dass sich die Luft gleichmäßig über die Lufteinlassseite des Wärmetauschers verteilt und durch diese hindurch tritt. Dadurch wird wiederum erreicht, dass der Wärmetauscher über seine gesamte Lufteinlassseite hinweg im Wesentlichen mit demselben Luftdruck beaufschlagt ist, so dass sich folglich über die gesamte Fläche des Wärmetauschers ein im Wesentlichen konstantes Luftgeschwindigkeitsprofil ausbildet. Weiterhin wird durch die gleichmäßige Luftbeaufschlagung des Wärmetauschers die Ausbildung von Strömungsgeschwindigkeitsspitzen vermieden und damit das Herausschleudern von Kondensat. Weiterhin erlaubt die beschriebene Luftführung, dass beispielsweise bei Wandanbaugeräten der Wärmetauscher senkrecht gestellt werden kann und trotzdem eine verbesserte Luftdurchdringung des Wärmetauschers erreicht wird. Durch die Senkrechtstellung des Wärmetauschers wird das Herausschleudern von Kondensat weiter vermindert. Weiterhin erlaubt die Senkrechtstellung des Wärmetauschers, dass sich die Bautiefe des Kühlgeräts verringert. Da der Wärmetauscher im Innenkreis nunmehr auch vor dem Luftauslass des Innenkreises angeordnet sein kann, ergibt sich eine größere Freiheit ach bei der Anordnung der übrigen Bauteile des Kühlgeräts.

Das beschriebene Kühlgerät weist gegenüber den aus dem Stand der Technik bekannten eine gesteigerte Energieeffizienz auf. Dies ermöglicht den Einsatz kleinerer Wärmetauscher und, im Falle einer Kältemaschine, kleinerer Verdichter. Durch die Reduzierung der Geräteabmessungen können auch die Herstellungskosten weiter verringert werden. Der verbesserte Wärmeabtausch durch die beschriebene Luftführung erlaubt es, dass eine Kältemaschine bei höherer Verdampfungstemperatur betrieben wird, wodurch zusätzlich die Gefahr der Kondensatbildung verringert wird.

Weitere Einzelheiten der Erfindung werden anhand der nachstehenden Figuren erläutert. Dabei zeigt:
- Figur 1: ein Kühlgerät im Querschnitt gemäß dem Stand der Technik; und
- Figur 2: eine Schaltschrankanordnung mit einem Kühlgerät im Querschnitt gemäß einer Ausführungsform der Erfindung.

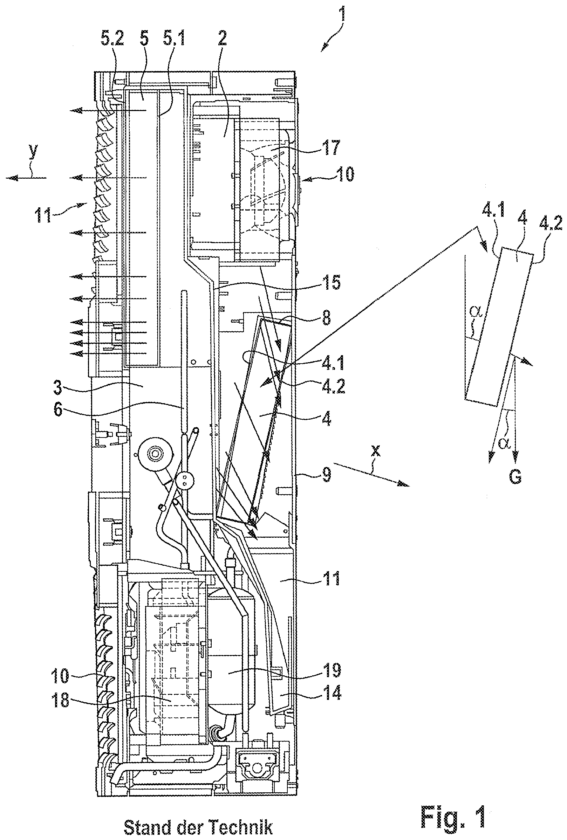

Die Figur 1 zeigt ein als Wandanbaugerät ausgebildetes Kühlgerät 1 für die Klimatisierung eines Schaltschranks, wie es aus dem Stand der Technik bekannt ist. Das Kühlgerät 1 weist einen Innenkreis 2 und einen Außenkreis 3 auf, die über eine Schottwand 15 fluidisch voneinander getrennt sind. Mit Hilfe eines ersten Lüfters 17 wird erwärmte Luft aus dem Schaltschrankinnenraum 101 über einen Lufteinlass 10 angesogen, durch den Innenkreis 2 und den darin angeordneten, ersten Wärmetauscher 4 hindurch geleitet und als gekühlte Luft über den Luftauslass 11 zurück in den Schaltschrankinnenraum 101 geführt.

Um eine bessere Luftdurchsetzung des ersten Wärmetauschers 4 im Innenkreis 2 zu erreichen, ist dieser schräg gestellt. Wie durch die eingezeichneten, den ersten Wärmetauscher 4 durchsetzenden Pfeile angedeutet ist, wird der erste Wärmetauscher 4 jedoch ungleichmäßig über seine Lufteinlassseite 4.1 angeströmt und insbesondere auch über seine obere Seitenfläche 8. Da ein Wärmetauscher 4, beispielsweise als Lamellen-Wärmetauscher ausgebildet, jedoch eine definierte Luftdurchlassrichtung x aufweist, ist die beschriebene Art der seitlichen AnStrömung des ersten Wärmetauschers 4 verlustträchtig. Insbesondere führt diese Anströmung des ersten Wärmetauschers 4 dazu, dass dieser über seine Bauhöhe ungleichmäßig von Luft durchströmt wird, so dass sich in bestimmten Bereichen des Wärmetauschers Luftdruck- und dementsprechend Luftgeschwindigkeitsspitzen ergeben, während andere Bereiche des Wärmetauschers 4 gar nicht oder kaum durchströmt sind.

Wie in Figur 1 der rechts wiedergegebenen Prinzipzeichnung zu entnehmen ist, führt die Schrägstellung des Wärmetauschers 4 in Kombination mit den sich ausbildenden Strömungsgeschwindigkeitsspitzen dazu, dass das im Wärmetauscher 4 gebildete Kondensat aus dem Wärmetauscher 4 heraustropft bzw. herausgeblasen wird. Um zu vermeiden, dass das herausgeschleuderte Kondensat über den Luftauslass 11 in den Schaltschrankinnenraum 101 gelangt, muss der erste Wärmetauscher 4 so angeordnet werden, dass die Luftauslassseite 4.2 von der Kühlgerätewand 9 bedeckt ist. Das herausgeschleuderte Kondensat kann dann in einem Kondensatabscheider 14 gesammelt und von dort abgeführt oder kontrolliert verdampft werden.

Der erste Wärmetauscher 4 ist über einen Kältemittelkreislauf 6 mit dem zweiten Wärmetauscher 5 im Außenkreis fluidisch verbunden. Neben dem zweiten Wärmetauscher 5 ist auch der Verdichter 19 im Außenkreis 3 angeordnet, um die von ihm erzeugte Abwärme einfach abführen zu können. Ein weiterer Lüfter 18 ist dazu vorgesehen, über den Lufteinlass 10 aus der Schaltschrankumgebung in den Außenkreis 3 zu saugen, durch den zweiten Wärmetauscher 5 hindurchzuführen und über den Luftauslass 11 zurück in die Umgebung abzuführen. Die weiteren, für eine Kältemaschine wesentlichen Bauteile, etwa ein Expansionsmittel und eine Regel- und Steuereinheit sind zur Vereinfachung der Darstellung nicht gezeigt.

Der erste und der zweite Wärmetauscher 4, 5 sind für einen optimalen Wärmeabtausch mit im vergleich zur Bautiefe großen Lufteinlassseiten 4.1, 5.1 und Luftauslassseiten 4.2, 5.2 ausgebildet. Im Vergleich dazu ist die Bautiefe der Wärmetauscher 4, 5 in Luftdurchlassrichtung x, y viel kleiner als die Abmessungen der Lufteinlassseiten 4.1, 5.1 und der Luftauslassseiten 4.2, 5.2. Dies führt dazu, dass die Wärmetauscher 4,5 bei einem Wandanbaugerät, wie es in Figur 1 gezeigt ist, im Wesentlichen senkrecht oder zur Verbesserung der Anströmung leicht schräg eingebaut werden müssen, wodurch sich erst die zuvor beschriebenen Probleme bei der Luftführung ergeben. Je weiter der Wärmetauscher 4 zur Optimierung der Luftdurchsetzung gekippt wird, desto mehr müsste die Bautiefe des Kühlgeräts 1 entsprechend erhöht werden.

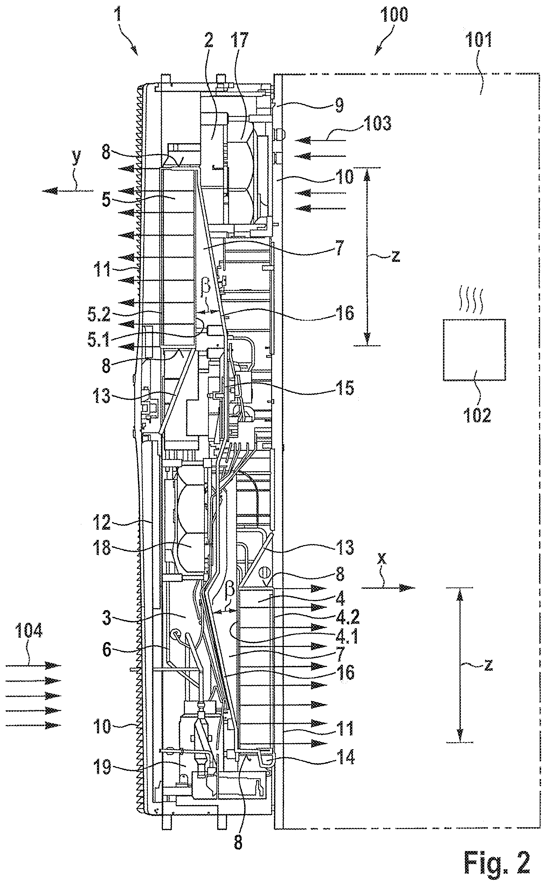

Die in Figur 2 gezeigte Schaltschrankanordnung nach einer Ausführungsform der Erfindung weist neben einem Kühlgerät 1 einen Schaltschrank 100 mit einem Schaltschrankinnenraum 101 auf, in dem Wärme abgebende Komponenten 102 angeordnet sind. Das Kühlgerät 1 ist darauf ausgelegt, die Schaltschrankinnenraumtemperatur auf einem Sollwert zu halten, welcher sich beispielsweise nach den optimalen Betriebsbedingungen für die Schaltschrankkomponenten 102 richtet.

Das Kühlgerät 1 weist wiederum einen Innenkreis 2 und einen Außenkreis 3 auf, wobei über einen ersten Lüfter 17 und einen Lufteinlass 10 Warmluft 103 aus dem Schaltschrankinnenraum 101 in den Innenkreis 2 eingesogen wird. Die eingesogene Luft wird durch den Innenkreis 2 und insbesondere den darin angeordneten ersten Wärmetauscher 4 hindurchgeführt, um als gekühlte Luft in einem unteren Bereich des Schaltschranks 100 in den Schaltschrankinnenraum 101 über einen Luftauslass 11 zurückgeleitet zu werden. Der Lufteinlassseite 4.1 des Wärmetauschers 4 im Innenkreis 2 ist ein erstes Luftleitelement 16 vorgelagert, das sich unter einem Winkel β zu der Lufteinlassseite 4.1 erstreckt. Das erste Luftleitelement 16 grenzt in einem unteren Bereich des Wärmetauschers 4 an die Lufteinlassseite 4.1 des Wärmetauschers 4 an. In der dargestellten Querschnittsansicht weist der zwischen der Lufteinlasseite 4.1 und dem ersten Luftleitelement 16 ausgebildete Luftkanal 7 eine sich verjüngende Form, etwa eine Keilform auf.

Die Keilform hat die technische Funktion, dass über die gesamte vertikale Abmessung z der Lufteinlassseite 4.1 im Wesentlichen derselbe Luftstaudruck an der Lufteinlassseite 4.1 bereitgestellt wird, so dass der Wärmetauscher 4 über seine gesamte Abmessung z mit einem Luftstrom derselben Geschwindigkeit durchsetzt und die Ausbildung von Geschwindigkeitsspitzen vermieden wird.

Weiterhin ist ein zweites Luftleitelement 13 vorgesehen, welches die Anströmung der Seitenfläche 8 des Wärmetauschers 4 vermeidet und stattdessen den die Seitenfläche 8 anströmenden Luftstrom vor die Lufteinlassseite 4.1 lenkt. Das erste Luftleitelement 16 verdeckt einen unteren Bereich des ersten Wärmetauschers 4, in welchem sich üblicherweise Kondensat sammelt. Das erste Luftleitelement 16 hat somit auch die Funktion, eine Luftbeaufschlagung des unteren Bereiches des Wärmetauschers 4 zu vermeiden, so dass das Herausschleudern von Kondensat weiter unterdrückt wird. Dies erlaubt es, dass der erste Wärmetauscher 4 fluchtend zu dem Luftauslass 11, über den der Innenkreis 2 in den Schaltschrankinnenraum 101 mündet, angeordnet werden kann, ohne dass die Gefahr besteht, dass Kondensat in den Schaltschrankinnenraum 101 geblasen werden könnte.

Der Außenkreis 3 ist ähnlich aufgebaut. Über einen zweiten Lüfter 18 wird Umgebungsluft 104 durch einen Lufteinlass 10 in den Außenkreis 3 eingesogen, durch den Außenkreis 3 und insbesondere den zweiten Wärmetauscher 5 hindurch und über den Luftauslass 11 zurück in die Schaltschrankumgebung geleitet. Auch der zweite Wärmetauscher 5 weist an seiner Lufteinlassseite 5.1 ein erstes Luftleitelement 16 auf, das sich unter einem Winkel β zu der Lufteinlassseite 5.1 erstreckt. Ein zweites Luftleitelement 13 ist dazu vorgesehen, das Anströmen der Seitenfläche 8 des zweiten Wärmetauschers 5 zu vermeiden und stattdessen die den zweiten Wärmetauscher 5 anströmende Luft vor die Lufteinlassseite 5.1 des zweiten Wärmetauschers 5 zu leiten. In dem Außenkreis ist weiterhin ein Verdichter 19 angeordnet, der über ein Leitungssystem, in dem ein Kältemittel 6 geführt ist, mit den beiden Wärmetauschern 4, 5 fluidisch verbunden ist, um einen Kältemittelkreislauf nach Art einer Kältemaschine zu bilden.

### Bezugszeichenliste

- 1: Kühlgerät
- 2: Innenkreis
- 3: Außenkreis
- 4: erster Wärmetauscher
- 4.1: Lufteinlassseite des ersten Wärmetauschers
- 4.2: Laufauslassseite des ersten Wärmetauschers
- 5: zweiter Wärmetauscher
- 5.1: Lufteinlassseite des zweiten Wärmetauschers
- 5.2: Luftauslassseite des zweiten Wärmetauschers
- 6: Kältemittel
- 7: Luftkanal
- 8: Seitenfläche
- 9: erste Kühlgerätewand
- 10: Lufteinlass
- 11: Luftauslass
- 12: zweite Kühlgerätewand
- 13: zweites Luftleitelement.
- 14: Kondensatabscheider
- 15: Schottwand
- 16: erstes Luftleitelement
- 17: erster Lüfter
- 18: zweiter Lüfter
- 19: Verdichter
- 100: Schaltschrank
- 101: Schaltschrankinnenraum
- 102: wärmeabgebende Komponenten
- 103: zu kühlende Luft
- 104: Umgebungsluft
- x: Luftdurchlassrichtung des ersten Wärmetauschers
- y: Luftdurchlassrichtung des zweiten Wärmetauschers
- z: Abmessung der Lufteinlassseite
- α: Kippwinkel des Wärmetauschers
- β: Anstellwinkel des ersten Luftleitelements in Bezug auf die Lufteinlassseite

## Patentansprüche

1. Schaltschrankanordnung, mit einem Schaltschrank (100), in dem an die Luft im Schaltschrankinnenraum (101) Wärme abgebende Komponenten (102) aufgenommen sind, und mit einem Kühlgerät (1) für die Kühlung der im Innenraum (101) des Schaltschranks (100) aufgenommenen Luft (103), das einen Innenkreis (2), durch den die zu kühlende Luft (103) aus einem Schaltschrankinnenraum (101) geführt ist, und einen von dem Innenkreis (2) fluidisch abgetrennten Außenkreis (3) aufweist, durch den Umgebungsluft (104) geführt ist, wobei die Luft aus dem Schaltschrankinnenraum (101) mit einem ersten Lüfter (17) durch den Innenkreis (2) und Umgebungsluft (104) der Schaltschrankanordnung mit einem zweiten Lüfter (18) durch den Außenkreis (3) geführt ist, wobei in dem Innenkreis (2) ein erster Wärmetauscher (4) und in dem Außenkreis (3) ein zweiter Wärmetauscher (5) angeordnet ist, zwischen denen ein Kältemittel (6) zirkuliert ist, wobei die Wärmetauscher (4, 5) eine Luftdurchlassrichtung (x, y) aufweisen, entlang welcher die Wärmetauscher (4, 5) zwischen einer Lufteinlassseite (4.1, 5.1) und einer Luftauslassseite (4.2, 5.2) luftdurchlässig sind, und wobei beiden Wärmetauschern (4, 5) jeweils ein erstes Luftleitelement (16) an der Lufteinlassseite (4.1, 5.1) vorgelagert ist, das sich unter einem Winkel (β) mit 5 < β < 45° zu der Lufteinlassseite (4.1, 5.1) erstreckt und einen Luftkanal (7) zwischen sich und der Lufteinlassseite (4.1, 5.1) bildet, der sich entlang einer Abmessung (z) der Lufteinlassseite (4.1, 5.1) verjüngt, wobei die beiden ersten Luftleitelemente (16) jeweils ein Wandabschnitt einer Schottwand (15) sind, die den Innenkreis (2) von dem Außenkreis (3) fluidisch abtrennt, wobei die beiden ersten Luftleitelemente (16) an diametral gegenüber liegenden Enden der Schottwand (15) ausgebildet sind, **dadurch gekennzeichnet, dass** das dem ersten Wärmetauscher (4) vorgelagerte Luftleitelement (16) einen unteren Bereich der Lufteinlassseite (4.1) verdeckt, so dass der erste Wärmetauscher (4) in diesem Bereich nicht von Luft durchströmt ist.

2. Schaltschrankanordnung nach Anspruch 1, bei der die Lufteinlassseite (4.1, 5.1) eine Vorderseite und die Luftauslassseite (4.2, 5.2) eine Rückseite des Wärmetauschers (4, 5) mit dem vorgelagerten ersten Luftleitelement (16) ist, die über Seitenflächen (8) des Wärmetauschers (4, 5) voneinander beabstandet sind, wobei der Wärmetauscher (4, 5) über eine der Seitenflächen (8) angeströmt ist, und wobei der Luftkanal (7) zu dieser Seitenfläche (8) hin geöffnet ist und sich zu einer gegenüber liegenden Seitenfläche (8) hin verjüngt.

3. Schaltschrankanordnung nach Anspruch 2, bei der die angeströmte Seitenfläche (8) ein zweites Luftleitelement (13) aufweist, über das die den Wärmetauscher (4, 5) seitlich anströmende Luft vor die Lufteinlassseite (4.1, 5.1) geführt ist.

4. Schaltschrankanordnung nach Anspruch 3, bei der das Kühlgerät (1) eine erste Kühlgerätewand (9) mit einem Lufteinlass (10) und einem Luftauslass (11) aufweist, zwischen denen der Innenkreis (2) gebildet ist, wobei das zweite Luftleitelement (13) beabstandet von dem Wärmetauscher (4, 5) in dem Innenkreis (2) an die erste Kühlgerätewand (9) angrenzt und sich von dort zu der Lufteinlassseite (4.1, 5.1) des Wärmetauschers (4, 5) erstreckt.

5. Schaltschrankanordnung nach Anspruch 3 oder 4, bei der das Kühlgerät (1) eine zweite Kühlgerätewand (12) mit einem Lufteinlass (10) und einem Luftauslass (11) aufweist, zwischen denen der Außenkreis (3) gebildet ist, wobei das zweite Luftleitelement (13) beabstandet von dem Wärmetauscher (4, 5) in dem Außenkreis (3) an die zweite Kühlgerätewand (12) angrenzt und sich von dort zu der Lufteinlassseite (4.1, 5.1) des Wärmetauschers (4, 5) erstreckt.

6. Schaltschrankanordnung nach einem der vorangegangenen Ansprüche, bei der der Wärmetauscher (4, 5) ein Luft-Kältemittel-Wärmetauscher, vorzugsweise ein Lamellen-Wärmetauscher oder ein Microchannel-Wärmetauscher ist, der in dem unteren Bereich und/oder angrenzend daran einen Kondensatabscheider (14) aufweist.

7. Schaltschrankanordnung nach einem der vorangegangenen Ansprüche, bei der das Kühlgerät (1) einen Luftauslass (11) zur Ausblasung von mittels des in dem Innenkreis (2) angeordnetem Wärmetauscher (4) gekühlter Luft aufweist, wobei die Luftauslassseite (4.1) des in dem Innenkreis (2) angeordneten Wärmetauschers (4) mit dem Luftauslass (11) überlappt.

8. Schaltschrankanordnung nach Anspruch 7, bei der der Öffnungsquerschnitt des Luftauslasses (11) parallel zu der Luftauslassseite (4.1) angeordnet ist und sich über die gesamte Luftauslassseite (4.1) erstreckt.

9. Schaltschrankanordnung nach einem der vorangegangenen Ansprüche, bei der sich die ersten Luftleitelemente (16), die zwischen sich und der jeweiligen Lufteinlassseite (4.1, 5.1) des jeweiligen Wärmetauschers (4,5) den Luftkanal (7) bilden, in einem Randbereich an die jeweilige Lufteinlassseite (4.1, 5.1) angrenzen und sich von dieser unter dem Winkel (β) erstrecken.

10. Schaltschrankanordnung nach einem der vorangegangenen Ansprüche, bei der sich die Abmessung (z) der Lufteinlassseite (4.1, 5.1), entlang welcher sich der Luftkanal (7) verjüngt, senkrecht zu der Luftdurchlassrichtung (x, y) der Wärmetauscher (4, 5) erstreckt.

## Claims

1. A switchgear cabinet arrangement, with a switchgear cabinet (100), in which components (102) dissipating heat to the air in the switchgear cabinet interior (101) are accommodated, and with a cooling unit (1) for cooling the air (103) admitted to the interior (101) of the switchgear cabinet (100), having an inner circuit (2), through which the air (103) to be cooled is routed from a switchgear cabinet interior (101), and an outer circuit (3) which is fluidically partitioned from the inner circuit (2) and through which the surrounding air (104) is routed, wherein the air from the switchgear cabinet interior (101) is routed by a first fan (17) through the inner circuit (2) and surrounding air (104 of the switchgear cabinet arrangement is routed by a second fan (18) through the outer circuit (3), and wherein the inner circuit (2) contains a first heat exchanger (4) and the outer circuit (3) contains a second heat exchanger (5), between which a coolant (6) is circulating, wherein the heat exchangers (4, 5) have an air flow direction (x, y) along which the heat exchangers (4, 5) allow air to pass between an air inlet side (4.1, 5.1) and an air outlet side (4.2, 5.2), and wherein the two heat exchangers (4, 5) have a first air guide (16) upstream on the air inlet side (4.1, 5.1), which extends at an angle (β) with 5 < β < 45° relative to the air inlet side (4.1, 5.1) and forms an air duct (7) between itself and the air inlet side (4.1, 5.1), which tapers along a dimension (z) of the air inlet side (4.1, 5.1), wherein the two first air guides (16) are each a wall section of a partition wall (15) which fluidically separates the inner circuit (2) from the outer circuit (3), wherein the two first air guides (16) are formed at diametrically opposite ends of the partition wall (15), **characterized in that** said first air guide (16) upstream of said first heat exchanger (4) covers a lower region of the air inlet side (4.1) so that air does not flow through the first heat exchanger (4) in this region.

2. The switchgear cabinet arrangement as claimed in claim 1, wherein the air inlet side (4.1, 5.1) is a front side and the air outlet side (4.2, 5.2) is a back side of the heat exchanger (4, 5) with the first air guide (16) located upstream, which are spaced apart from each other by side surfaces (8) of the heat exchanger (4, 5), wherein the heat exchanger (4, 5) is bathed in a flow across one of the side surfaces (8), and wherein the air duct (7) is open toward this side surface (8) and tapers toward an opposite situated side surface (8).

3. The switchgear cabinet arrangement as claimed in claim 2, wherein the side surface (8) bathed in the flow has a second air guide (13), by which the air flowing from the side onto the heat exchanger (4, 5) is routed upstream from the air inlet side (4.1, 5.1).

4. The switchgear cabinet arrangement as claimed in claim 3, wherein the cooling unit (1) has a first cooling unit wall (9) with an air inlet (10) and an air outlet (11), between which the inner circuit (2) is formed, wherein the second air guide (13) borders on the first cooling unit wall (9) at a distance from the heat exchanger (4, 5) in the inner circuit (2) and extends from there to the air inlet side (4.1, 5.1) of the heat exchanger (4, 5).

5. The switchgear cabinet arrangement as claimed in claim 3 or 4, wherein the cooling unit (1) has a second cooling unit wall (12) with an air inlet (10) and an air outlet (11), between which the outer circuit (3) is formed, wherein the second air guide (13) borders on the second cooling unit wall (12) at a distance from the heat exchanger (4, 5) in the outer circuit (3) and extends from there to the air inlet side (4.1, 5.1) of the heat exchanger (4, 5).

6. The switchgear cabinet arrangement as claimed in one of the preceding claims, wherein the heat exchanger (4, 5) is an air/coolant heat exchanger, preferably a fin-type heat exchanger or a microchannel heat exchanger, having a condensate separator (14) in the lower region and/or adjacent thereto.

7. The switchgear cabinet arrangement as claimed in one of the preceding claims, wherein the cooling unit (1) has an air outlet (11) for blowing out air cooled by means of the heat exchanger (4) arranged in the inner circuit (2), wherein the air outlet side (4.1) of the heat exchanger (4) arranged in the inner circuit (2) overlaps with the air outlet (11).

8. The switchgear cabinet arrangement as claimed in claim 7, wherein the opening cross section of the air outlet (11) is arranged parallel with the air outlet side (4.1) and extends across the entire air outlet side (4.1).

9. The switchgear cabinet arrangement as claimed in one of the preceding claims, wherein the first air guides (16) which form the air duct (7) between themselves and the respective air inlet side (4.1, 5.1) of the respective heat exchanger (4, 5) border the respective air inlet side (4.1, 5.1) in an edge region and extend therefrom at the angle (13).

10. The switchgear cabinet arrangement as claimed in one of the preceding claims, wherein the dimension (z) of the air inlet side (4.1, 5.1) along which the air duct (7) tapers extends perpendicular to the air flow direction (x, y) of the heat exchanger (4, 5).

## Revendications

1. Disposition d'armoire de commande avec une armoire de commande (100), dans laquelle sont logés des composants (102) dégageant de la chaleur dans l'air, dans l'espace intérieur de l'armoire de commande (101), et avec un appareil de refroidissement (1) pour le refroidissement de l'air (103) logé dans l'espace intérieur (101) de l'armoire de commande (101), qui comprend un circuit interne (2), grâce auquel l'air à refroidir (103) est guidé hors de l'espace intérieur de l'armoire de commande (101) et un circuit externe (3) séparé fluidiquement du circuit interne (2), grâce auquel l'air ambiant (104) est guidé, l'air étant guidé hors de l'espace intérieur de l'armoire de commande (101) avec un premier ventilateur (17) grâce au circuit interne (2) et l'air ambiant (104) de la disposition d'armoire de commande étant guidé avec un deuxième ventilateur (18) à travers le circuit externe (3), moyennant quoi, dans le circuit interne (2) est disposé un premier échangeur thermique (4) et dans le circuit externe (3), est disposé un deuxième échangeur thermique (5), entre lesquels circule un produit de refroidissement (6), les échangeurs thermiques (4, 5) comprenant une direction de passage d'air (x, y) le long de laquelle les échangeurs thermiques (4, 5) sont perméables à l'air entre un côté d'entrée d'air (4.1, 5.1) et un côté de sortie d'air (4.2, 5.2) et, en amont de chacun des deux échangeurs thermiques (4, 5), un premier élément de guidage d'air (16) étant disposé sur le côté d'entrée d'air (4.1, 5.1), qui s'étend avec un angle (β) avec 5 < β < 45° par rapport au côté d'entrée d'air (4.1, 5.1) et formant un canal d'air (7), entre celui-ci et le côté d'entrée d'air (4.1, 5.1), qui se rétrécit le long d'une dimension (z) du côté d'entrée d'air (4.1, 5.1), les deux premiers éléments de guidage d'air (16) étant chacun une portion de paroi d'une cloison (15), qui sépare fluidiquement le circuit interne (2) du circuit externe (3), les deux premiers éléments de guidage d'air (16) étant réalisés sur des extrémités diamétralement opposées de la cloison (15), **caractérisé en ce que** le premier élément de guidage d'air (16) disposé en amont du premier échangeur thermique (4) recouvre une zone inférieure du côté d'entrée d'air (4.1), de façon à ce que le premier échangeur thermique (4) ne soit pas traversé par de l'air dans cette zone.

2. Disposition d'armoire de commande selon la revendication 1, dans laquelle le côté d'entrée d'air (4.1, 5.1) est un côté avant et le côté de sortie d'air (4.2, 5.2) est un côté arrière de l'échangeur thermique (4, 5) avec le premier élément de guidage d'air (16) disposé en amont, qui sont écartés entre eux par des surfaces latérales (8) de l'échangeur thermique (4, 5), l'échangeur thermique (4, 5) étant alimenté par une des surfaces latérales (8) et le canal d'air (7) étant ouvert en direction de cette surface latérale (8) et se rétrécissant vers une surface latérale (8) opposée.

3. Disposition d'armoire de commande selon la revendication 2, dans laquelle la surface latérale (8) alimentée comprend un deuxième élément de guidage d'air (13) par l'intermédiaire duquel l'air alimentant latéralement l'échangeur thermique (4, 5) est guidé avant le côté d'entrée d'air (4.1, 5.1).

4. Disposition d'armoire de commande selon la revendication 3, dans laquelle l'appareil de refroidissement (1) comprend une première paroi d'appareil de refroidissement (9) avec une entrée d'air (10) et une sortie d'air (11), entre lesquelles le circuit interne (2) est formé, le deuxième élément de guidage d'air (13) étant adjacent, avec une certaine distance par rapport à l'échangeur thermique (4, 5) dans le circuit interne (2), à la première paroi d'appareil de refroidissement (9) et s'étendant de là en direction du côté d'entrée d'air (4.1, 5.1) de l'échangeur thermique (4, 5).

5. Disposition d'armoire de commande selon la revendication 3 ou 4, dans laquelle l'appareil de refroidissement (1) comprend une deuxième paroi d'appareil de refroidissement (12) avec une entrée d'air (10) et une sortie d'air (11), entre lesquelles le circuit externe (3) est formé, le deuxième élément de guidage d'air (13) étant adjacent, avec une certaine distance par rapport à l'échangeur thermique (4, 5) dans le circuit externe (3), à la deuxième paroi d'appareil de refroidissement (12) et s'étendant de là en direction du côté d'entrée d'air (4.1, 5.1) de l'échangeur thermique (4, 5).

6. Disposition d'armoire de commande selon l'une des revendications précédentes, dans laquelle l'échangeur thermique (4, 5) est un échangeur thermique air-produit de refroidissement, de préférence un échangeur thermique à lamelles ou un échangeur thermique à microcanaux, qui comprend, dans la zone inférieure et/ou près de celle-ci, un séparateur de condensat (14).

7. Disposition d'armoire de commande selon l'une des revendications précédentes, dans laquelle l'appareil de refroidissement (1) comprend une sortie d'air (11) pour l'évacuation de l'air refroidi par l'échangeur thermique (4) disposé dans le circuit interne (2), le côté de sortie d'air (4.1) de l'échangeur thermique (4) disposé dans le circuit interne (2) se superposant avec la sortie d'air (11).

8. Disposition d'armoire de commande selon la revendication 7, dans laquelle la section transversale d'ouverture de la sortie d'air (11) est parallèle au côté de sortie d'air (4.1) et s'étend sur tout le côté de sortie d'air (4.1).

9. Disposition d'armoire de commande selon l'une des revendications précédentes, dans laquelle les premiers éléments de guidage d'air (16), qui forment le canal d'air (7) entre eux et le côté d'entrée d'air (4.1, 5.1) correspondant de l'échangeur thermique (4, 5) correspondant, sont adjacents, dans une zone de bord, au côté d'entrée d'air (4.1, 5.1) correspondant et s'étendant à partir de celui-ci avec un angle (β).

10. Disposition d'armoire de commande selon l'une des revendications précédentes, dans laquelle la dimension (z) du côté d'entrée d'air (4.1, 5.1), le long de laquelle le canal d'air (7) se rétrécit, s'étend perpendiculairement à la direction de passage d'air (x, y) des échangeurs thermiques (4, 5).
